# EUROPEAN PATENT APPLICATION

(11) **EP 1 172 962 A2**
(43) Date of publication of application: **16.01.2002**
(21) Application number: 01305957.1
(22) Date of filing: 10.07.2001
(51) Int. Cl.: H04L 7/033

(54) **Bit rate agile clock recovery circuit**

(30) Priority: 13.07.2000 US 615420
(71) Applicant: Tektronix, Inc., Beaverton, OR 97077 (US)
(72) Inventor: Traa, Einar O., Portland, Oregon 97225 (US)
(74) Representative: Molyneaux, Martyn William

(57) **Abstract**

A bit rate agile recovery circuit that performs instant lock-on clock recovery without glitches has a tunable voltage controlled oscillator providing a pair of quadrature phase clock signals. The quadrature phase clock signals are sampled by transitions in an input digital data signal to generate a phase code. The phase code and quadrature phase clock signals are input to a clock phase select circuit that selects one of four clock phases as the recovered clock. The clock phase select circuit has a cascade of transistor circuits and a single current source so that, if either bit of the phase code is metastable, two adjacent clock phases are partially selected with a total sum of one. The change from one clock phase to the next occurs when both clock phases are the same so no glitches occur.

## Description

### BACKGROUND OF THE INVENTION

The present invention relates to the recovery of clock information from a digital data signal, and more particularly to a bit rate agile clock recovery circuit that performs instant lock-on clock recovery without glitches.

Traditional narrow-band clock recovery circuits, such as those based on LC tanks, SAW filters or phase locked loops (PLLs), suffer from the fundamental limitation of locking, i.e., reaching steady-state operation slowly compared to an input data rate. This is inconsequential in classical digital links where phase-coherent data flows continuously. However if data arrives in asynchronous packets as in modern telecommunication systems such as passive optical networks, long locking times cause significant problems in transmission efficiency.

The early solutions for fast-locking clock recovery were based on analog PLLs (see "A Single Chip NMOS Ethernet Controller" by A.G. Bell and G. Borriello, Digest of Technical Papers, IEEE ISSCC, pp. 70-71, February 1983), but these circuits still required small preambles, typically 5-15 bits, and/or bandwidth-wasting line coding, such as Manchester coding. A different integrated solution is provided by an over-sampled analog/digital approach (see "A 30 MHz High-Speed Analog/Digital PLL in 2 µm CMOS" by B. Kim, D.N. Helman and R.R. Gray, Digest of Technical Papers, IEEE ISSCC, pp. 104-105, February 1990). These circuits may be designed to work with non-return to zero (NRZ) data and with very small or no preambles. However due to the significant amount of fast digital circuitry required and to subtle problems, such as latch metastability, this approach is very difficult at high frequencies in the gigahertz range. Also the resulting circuits tend to be large and to dissipate large amounts of power. The clock recovery method proposed by M. Banu and A.E. Dunlop, "660 Mb/s CMOS Clock Recovery Circuit with Instantaneous Locking", Electronics Letters, Vol. 28, No. 23, pp. 2127-2130, November 5, 1992, avoids most of these problems inherently. Lock is accomplished instantaneously on the first data transition without over-sampling and is suitable for low-power and/or high-frequency operation.

The Banu/Dunlop proposed method uses three matched gated voltage controlled oscillators, with two of the oscillators being zero-phase-started and stopped alternately by data transitions and the third allowed to run continuously. The output of the third oscillator is fed into a conventional charge-pumped PLL and phase locked to a local reference signal. Since the same control voltage is applied to all three oscillators, the output frequencies of the first two are in precise relationships to the reference frequency for all process and temperature conditions within a small but finite matching error. This indirect frequency tuning technique operates continuously and is not affected by the on/off state of the first two oscillators at any particular time. Combining continuous frequency tuning with data-transition-triggered zero-phase start is sufficient to reconstruct the clock instantaneously. The phase errors that accumulate between transitions of the first two oscillators due to their frequency mismatches to the actual data rate are discarded every time the oscillators are stopped. The open-loop nature of this technique provides great locking agility, but the clock inherits all the timing errors of the data transitions, such as input signal duty-cycle distortion. An optional divide-by-two may be used to insure that the oscillators are triggered only by up or down transitions at the expense of effectively halving the input transition density. A more serious data timing error is due to phase noise or jitter. An elastic store may be added to the clock recovery circuit, the noisy data being input to a FIFO and read out by a clean local clock.

The Banu/Dunlop approach requires that two oscillators match in frequency roughly within 1/2000, depending upon the data transmission protocol. This requirement has to be met while the two oscillators are tuned over a frequency range of 1.5-3 GHz for current high-speed transmission systems, especially those carrying baseband high definition television data.

What is desired is a bit rate agile instantaneous clock recovery circuit for gigahertz data transmission systems that is relatively simple and provides clock transitions without glitches.

### BRIEF SUMMARY OF THE INVENTION

Accordingly the present invention provides a bit rate agile clock recovery circuit that generates from a VCO and PLL combination a pair of quadrature phase clock signals at approximately the frequency of an input digital data signal, the frequency being determined by a reference control signal input to the PLL. The quadrature phase clock signals are not phase locked to the input digital data signal. A clock phase select circuit has as inputs the pair of quadrature phase clock signals and a code generated from the pair of quadrature phase clock signals by the transitions in the input digital data signal. Based upon the code the clock phase select circuit selects one of four phases of the VCO clock frequency as the regenerated clock that is then used to extract the data from the input digital data signal.

The objects, advantages and other novel features are apparent from the following detailed description when read in conjunction with the appended claims and attached drawing.

### BRIEF DESCRIPTION OF THE SEVERAL VIEWS OF THE DRAWING

Fig. 1 is a block diagram view of a bit rate agile clock recovery circuit according to the present invention.

Fig. 2 is a block diagram view of a flip-flop triggered on both clock edges for the bit agile clock recovery circuit according to the present invention.

Fig. 3 is a circuit diagram view of a clock phase select circuit for the bit rate agile clock recovery circuit according to the present invention.

Fig. 4 is a waveform diagram view illustrating the transition between phases of the VCO clock frequency for the bit rate agile clock recovery circuit according to the present invention.

Fig. 5 is a waveform diagram view of various waveforms associated with the bit rate agile clock recover circuit according to the present invention.

### DETAILED DESCRIPTION OF THE INVENTION

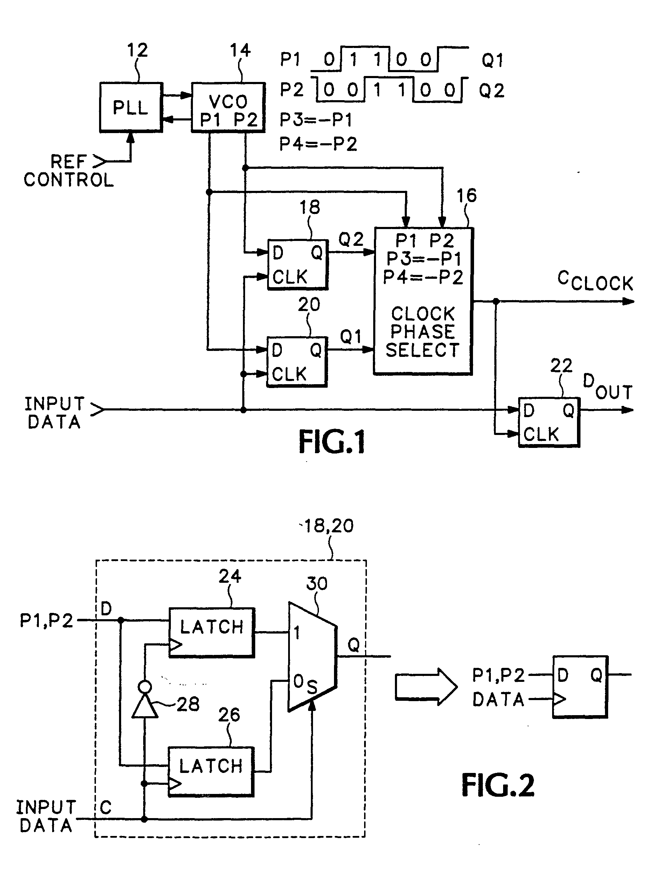

Referring now to Fig. 1 a phase locked loop (PLL) **12** is used to control the frequency of a tunable voltage controlled oscillator (VCO) **14.** The frequency of the VCO **14** is determined by a reference control signal input to the PLL **12.** The VCO **14** may be a two stage ring oscillator. The outputs from the VCO **14** are a pair of differential clock signals **P1, P2** in quadrature phase which are input to a clock phase select circuit **16.** The quadrature phase clock signals are not phase locked to the input digital data signal, but are set to the approximate frequency expected for the input digital data signal. The pair of differential clock signals **P1, P2** also are input to respective flip-flops **18, 20** at the data input terminals. An input digital data signal is input to the clock input terminals of the flip-flops **18, 20.** The pair of differential clock signals **P1, P2** are inverted by the clock phase select circuit **16** so that there exist two additional pairs of differential clock signals **P3, P4** for selecting from. The Q outputs from the flip-flops **18, 20** are input to the clock phase select circuit **16** which selects one of the four pairs of differential signals **P1, P2, P3, P4** as an output clock signal **C** based upon the outputs from the flip-flops. The output clock signal **C** clocks another flip-flop **22** to which the input digital data signal is input at the data input terminal to recover the data **D.** A delay at the data input of the data flip-flop **22** may be used to assure that clock phase selection is not changed just as the input is changing.

In operation the two pairs of quadrature clock outputs **P1, P2** from the VCO **14** are sampled by the two flip-flops **18, 20** on transitions of the input digital data signal. The samples are held as **Q1, Q2.** The flip-flops may be clocked on both positive and negative edges to extract all available timing information from the input digital data signal. Such a flip-flop is shown in Fig. 2 having a pair of latches **24, 26** to which the quadrature clock signals **P1,P2** are applied and an inverter **28** coupled to the clock input of one of the two latches, with the input data being applied to the input of the inverter and to the clock input of the other of the two latches. The outputs of the two latches **24, 26** are applied as inputs to an output multiplexer **30**, to which the input data signal is applied as a select signal. Therefore on positive transitions of the input data signal the value of the clock signal is latched in one latch and on negative transitions the value of the clock signal is latched in the other latched. Simultaneously the output of one latch is output by the multiplexer while the other latch is being loaded.

The samples **Q1, Q2** define how the input signal phase is related to the clock phases **P1, P2, P3, P4** as illustrated by the waveform in Fig. 1. The "1"s and "0"s on the **P1** and **P2** waveforms are the values of **Q1** and **Q2** when sampled during that time. The clock phase select circuit **16** uses the **Q1, Q2** values to select the clock phase **P1-P4** which fits the timing of the input data transition best. That phase is output as clock **C**.

If the VCO **14** is perfectly matched in frequency to the input signal clock frequency, the selected phase from the clock phase select circuit **16** does not change. When there is a mismatch, which is generally the case in an imperfect world, the selected phase cycles **1-4** over and over again, either backwards or forwards, at the beat frequency of the two clocks. Therefore the VCO frequency should match the input signal clock frequency well enough so that it drifts less than one phase, i.e., one quarter cycle, in the longest period of no transitions in the input data signal. In SONET OC-48 this is the 384 bits still unscrambled immediately following the A1, A2 framing signal. Thus for SONET OC-48 the VCO frequency needs to match the input data signal frequency better than 1/1546, or about 500 ppm.

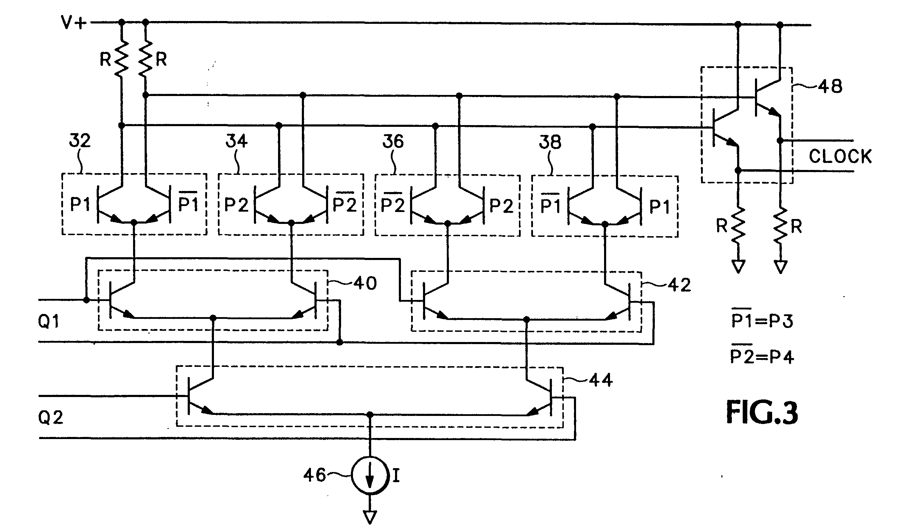

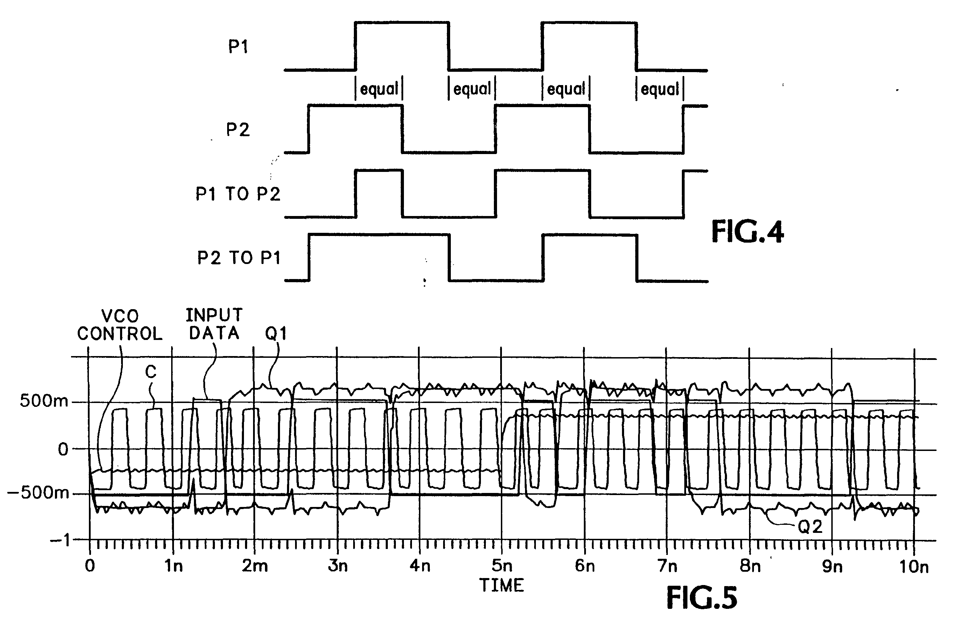

The clock phase select circuit **16** is shown in greater detail in Fig. 3. This circuit is designed to interpolate between adjacent phases if there is metastability in either **Q1** or **Q2** in order to make it "metastable proof." If there is metastability in either of the sampling flip-flops **18, 20,** partials of two adjacent phases of the recovered clock which add to one are chosen. When there is a clock phase change, the circuit is designed to change during a time when the old phase and new phase are equal, as shown in Fig. 4, to avoid generating glitches. This circuit has four phase differential transistor circuits **32, 34, 36, 38** to which clock phase pairs **P1, P3** and **P2, P4** are applied, with two of the circuits being reversed from the other two. A cascade of drive differential transistor circuits **40, 42, 44** are configured to receive the **Q1, Q2** samples, and the entire cascade of transistor circuits **32-44** is driven by a current source **46.** The single current source **46** at the bottom of the cascade of transistor circuits **32-44** insures that two adjacent clock phases are partially selected with a total sum of one if there is metastability in either sampling flip-flop **18, 20.** The outputs from the collectors of the phase differential transistor circuits **32-38** are coupled to an output differential emitter follower transistor circuit **48** to provide the selected phase clock output **C.**

Referring now to the waveforms shown overlaid in Fig. 5, the VCO control voltage is shown at a negative value for the first five nanoseconds and positive for the next five nanoseconds. This indicates that the VCO frequency is too low for the first five nanoseconds and too high for the next five nanoseconds. The first phase select bit **Q1** is negative until about 1.7 nanoseconds and then goes positive until about 5.3 nanoseconds, returns to positive at about 5.7 nanoseconds until about 9.3 nanoseconds. The second phase select bit **Q2** is negative until about 3.7 nanoseconds, and returns negative at about 7.3 nanoseconds. Therefore until 1.7 nanoseconds **P3** is the selected clock phase output **C,** at which point **P4** is selected. At 3.7 nanoseconds **P1** is selected and at 5.3 nanoseconds **P2** is selected. Then at 5.7 nanoseconds **P1** is selected and at 7.3 nanoseconds **P4** is selected. Finally at 9.3 seconds **P3** is selected. Note that at these times when the clock phase changes, the recovered clock cycles change ― while the VCO frequency is slow relative to the input data signal frequency the clock cycle at the phase change times is shorter, while conversely the phase change times are longer at the phase change times when the VCO frequency is fast relative to the input data signal frequency. Also note that the phase cycles in one direction ― P3, P4, P1, P2 ― and then changes direction ― P2, P1, P4, P3 ― depending upon the relative frequency relationship between the VCO frequency and the input data signal frequency.

The bit rate agile clock recovery circuit described above may be built almost entirely from standard digital building blocks, except for the tunable voltage controlled oscillator **12** which of necessity has a tunable analog feature. The jitter of the recovered clock **C** has a peak-to-peak value of 0.25 unit intervals (UI), which is the time allocated to each bit, due to the phase select circuit **16.** Since the clock **C** is used only internally to recover the data from the input digital data signal, this jitter is not of concern.

Thus the present invention provides a bit rate agile clock recovery circuit by generating a pair of quadrature clock signals from a VCO and PLL combination, and selecting one of four clock phases to use based upon the phase of the quadrature clock signals when the input data transitions.

## Claims

1. A bit rate agile clock recovery circuit comprising:
means for generating a pair of quadrature phase clock signals at a frequency approximately equal to the frequency of an input digital data signal;
means for sampling the pair of quadrature phase clock signals as a function of transitions in the input digital data signal to produce a phase code; and
means for selecting as a recovered clock one of four clock phases from the pair of quadrature phase clock signals as a function of the phase code.

2. The circuit as recited in claim 1 wherein the generating means comprises:
a tunable voltage controlled oscillator; and
a phase locked loop coupled to the tunable voltage controlled oscillator, the phase locked loop receiving a reference control signal that determines the frequency of the tunable voltage controlled oscillator.

3. The circuit as recited in claim 1 wherein the sampling means comprises:
a first flip-flop having one of the quadrature phase clock signals as a data input and the input digital data signal as a clock input, and providing one bit of the phase code as an output; and
a second flip-flop having the other of the quadrature phase clock signals as a data input and the input digital data signal as a clock input, and providing one bit of the phase code as an output, the phase code being a two-bit code.

4. The circuit as recited in claim 1 wherein the selecting means comprises:
a transistor clock driver having an input and providing the recovered clock at an output;
four transistor current switches at a first level, each having a pair of inputs to which one of the quadrature phase clock signals and an inversion of one of the quadrature phase clock signals are coupled and each being coupled to the input of the transistor clock driver;
a pair of transistor current switches at a second level, each having a pair of inputs to which one bit of the phase code and its inverse are coupled and each being coupled to a pair of the transistor current switches at the first level;
a final transistor current switch as a third level having a pair of inputs to which the other bit of the phase code and its inverse are coupled and being coupled to the pair of transistor current switches at the second level; and
a current source coupled to the final transistor current switch such that one of the four clock phases is selected as the recovered clock from the quadrature phase clock signals as a function of the phase code.

5. A method of recovering a bit rate agile clock signal from an input digital data signal comprising the steps of:
generating a pair of quadrature phase clock signals at a frequency approximately equal to the frequency of the input digital data signal;
sampling the pair of quadrature phase clock signals as a function of transitions in the input digital data signal to produce a phase code; and
selecting as the bit rate agile clock signal one of four clock phase signals from the pair of quadrature clock signals as a function of the phase code.

6. An apparatus for recovering a bit rate agile clock signal from an input digital data signal comprising:
a tunable oscillator having a frequency control input and a pair of quadrature phase clock signals as output;
a sampler having the pair of quadrature phase clock signals from the controllable oscillator and the input digital data signal as inputs and having a phase code as output, the phase code being a function of transitions of the input digital data signal; and
a clock phase selector having as inputs the pair of quadrature phase clock signals from the controllable oscillator and the phase code from the encoder and having as an output the bit rate agile clock signal selected from one of four phases of the pair of quadrature phase clock signals as a function of the phase code.

7. The circuit as recited in claim 6 wherein the tunable oscillator comprises:
a tunable voltage controlled oscillator; and
a phase locked loop coupled to the tunable voltage controlled oscillator, the phase locked loop receiving a reference control signal that determines the frequency of the tunable voltage controlled oscillator..

8. The circuit as recited in claim 6 wherein the sampler comprises:
a first flip-flop having one of the quadrature phase clock signals as a data input and the input digital data signal as a clock input, and providing one bit of the phase code as an output; and
a second flip-flop having the other of the quadrature phase clock signals as a data input and the input digital data signal as a clock input, and providing one bit of the phase code as an output, the phase code being a two-bit code.

9. The circuit as recited in claim 6 wherein the clock phase selector comprises:
a transistor clock driver having an input and providing the recovered clock at an output;
four transistor current switches at a first level, each having a pair of inputs to which one of the quadrature phase clock signals and an inversion of one of the quadrature phase clock signals are coupled and each being coupled to the input of the transistor clock driver;
a pair of transistor current switches at a second level, each having a pair of inputs to which one bit of the phase code and its inverse are coupled and each being coupled to a pair of the transistor current switches at the first level;
a final transistor current switch as a third level having a pair of inputs to which the other bit of the phase code and its inverse are coupled and being coupled to the pair of transistor current switches at the second level; and
a current source coupled to the final transistor current switch such that one of the four clock phases is selected as the recovered clock from the quadrature phase clock signals as a function of the phase code.
